Europäisches Patentamt

European Patent Office

Office européen des brevets

(11) Veröffentlichungsnummer: **0 166 893**
**B1**

(12) # EUROPÄISCHE PATENTSCHRIFT

(45) Veröffentlichungstag der Patentschrift:
**18.01.89**

(51) Int. Cl.⁴: **H 01 L 21/308,** H 01 L 21/316,
H 01 L 21/306

(21) Anmeldenummer: **85104927.0**

(22) Anmeldetag: **23.04.85**

(54) **Trockenätzverfahren.**

(30) Priorität: **04.05.84 CH 2174/84**

(43) Veröffentlichungstag der Anmeldung:
**08.01.86 Patentblatt 86/2**

(45) Bekanntmachung des Hinweises auf die Patenterteilung:
**18.01.89 Patentblatt 89/3**

(84) Benannte Vertragsstaaten:
**CH DE FR GB IT LI NL SE**

(56) Entgegenhaltungen:
EP-A- 0 022 280
DE-A- 1 621 525
FR-A- 2 081 915
FR-A- 2 088 446
FR-A- 2 253 280

THIN SOLID FILMS, Band 103, Nr. 1/2, Mai 1983, Seiten 167-175, Elsevier Sequoia, NL, Lausanne; P.A. BERTRAND et al.: "Chemical deposition of TiO2 layers on GaAs"
JOURNAL OF THE ELECTROCHEMICAL SOCIETY, Band 118, Nr. 3, März 1971, Seite 66C, Princeton; E.T. FITZGIBBONS et al.: "Production and Properties of TiO2 films. III. Properties applicable to electron device technology"
JOURNAL OF THE ELECTROCHEMICAL SOCIETY,

(73) Patentinhaber: **BBC Brown Boveri AG, Haselstrasse,
CH-5401 Baden (CH)**

(72) Erfinder: **Gobrecht, Jens, Dr., Birchhofstrasse 6,
CH-5412 Gebenstorf (CH)**
Erfinder: **Rossinelli, Marco, Dr., Schönbühlstrasse 20,
CH-5442 Fislisbach (CH)**

(56) Entgegenhaltungen: (Fortsetzung)
Band 126, Nr. 3, März 1979, Seiten 464-469, Princeton; G.C. SCHWARTZ et al.: "Competitive mechanisms in reactive ion etching in a CF4 plasma"
IBM TECHNICAL DISCLOSURE BULLETIN, Band 21, Nr. 4, September 1978, Seiten 1466-1467, New York, US; J.S. LOGAN et al.: "Method of etching/filling deep trench isolation for large-scale integrated devices"

**Beschreibung**

Die vorliegende Erfindung geht aus von einem Trockenätzverfahren zur Strukturierung eines Substrats gemäss dem Oberbegriff des Anspruchs 1. Ein solches Verfahren ist z.B. aus der Druckschrift IBM TDB Vol. 21, No. 4, S. 1466–67 bekannt.

Trockenätzprozesse, d.h. Plasma- und Reaktiv-Ionenätztechniken haben sich allgemein in der Mikroelektronik-Fertigung durchgesetzt, da sie gegenüber den früher üblichen Nassätzverfahren eine Reihe von Vorteilen aufweisen. Einer der wichtigsten Vorteile besonders des Reaktiv-Ionenätzens ist der Umstand, dass dem Ätzvorgang im Substratmaterial, hier besonders im Halbleitermaterial Silizium, eine Vorzugsrichtung gegeben werden kann, d.h. dass anisotrope Ätzvorgänge durchgeführt werden können.

Diesen Anisotropie-Effekt erhält man dadurch, dass das Substratmaterial mit Ionen des Ätzgases senkrecht zur Substratoberfläche bombardiert wird. Damit verbunden sind jedoch gewisse unerwünschte Kathodenzerstäubungseffekte, die zu einer Erosion der beim Ätzvorgang verwendeten Ätzmaske führen.

Als Maskenmaterial für die Ätzmaske wird in der Halbleiterfertigung bei diesen Trockenätzprozessen üblicherweise Photolack verwendet. Die Gründe hierfür sind das besonders einfache Auftragen, Strukturieren und Entfernen des Photolacks nach dem Ätzen. Andererseits ist gerade die wünschenswerte Ätzresistenz von solchen Photolacken insbesondere gegenüber fluorhaltigen Ätzplasmen nur mittelmässig. Die diesen Zusammenhang quantitativ beschreibende Grösse ist die Ätzselektivität, d.h. das Verhältnis der Ätzraten des Substratmaterials und des Maskenmaterials, wobei die Ätzraten in abgetragener Materialdicke pro Zeiteinheit ausgedrückt werden. Die Ätzselektivität beispielsweise von Silizium gegenüber Photolack hängt stark von den Bedingungen ab, die in dem für die Ionenätzung verwendeten Plasma-Reaktor herrschen. So sind für ein aus $SF_6$-Gas erzeugtes Plasma Ätzselektivitäten von 1 bis 50 bekannt.

In jedem Fall sind die Ätzselektivitäten dann klein, wenn der Ätzprozess so geführt wird, dass der Ätzvorgang anisotrop verläuft, was in den meisten Fällen erwünscht ist. Bei einem solchen anisotropen Ätzvorgang ergeben sich lediglich Ätzselektivitäten von 3 bis 4. Ähnliche Werte gelten auch bei der Verwendung von $CF_4$ als Ätzgas.

Für die Ätzung von etwa 1 µm dicken Polysilizium-Strukturen reichen die genannten Ätzselektivitäten zwar aus, so dass der Photolack als Ätzmaske für Trockenätzprozesse eine entsprechend breite Verwendung gefunden hat. Für die Zukunft lassen sich jedoch Tendenzen in der Halbleitertechnologie erkennen, die insbesondere zur Suche nach Ätzmasken mit deutlich höherer Ätzresistenz zwingen. Die Gründe dafür sind die immer kleiner werdenden Dimensionen der Strukturelemente in hochintegrierten Festkörperschaltkreisen und die für bestimmte Bauelemente notwendigen grösseren Ätztiefen. So werden beispielsweise bei der sogenannten «trench isolation technology» für integrierte Schaltungen in CMOS-Technik 1–2 µm schmale Trennungsgräben von etwa 10 µm Tiefe benötigt, um die Einzelelemente der Schaltung gegeneinander zu isolieren. Die Ätzung derartig feiner und tiefer Strukturen durch Trockenätzprozesse ist bei der Verwendung von Photolack als Ätzmaske praktisch nicht möglich.

Aus der IEEE Trans. on Electr. Dev. Vol. ED-28, No. 11, Nov. 1981, S. 1320–23 ist nun ein Reaktiv-Ionenätzverfahren bekannt, bei dem durch anisotropes Ätzen in einem $Ar/Cl_2$-Plasma schmale und tiefe Gräben in ein Si-Substrat eingeätzt werden. Für verschiedene Ätzmaskenmaterialien werden dabei Ätzselektivitäten von 50–100 erreicht, wenn während des Ätzvorgangs durch Zusatz von $SiCl_4$ und $O_2$ auf der Ätzmaske fortlaufend $SiO_x$ abgeschieden wird, so dass die Ätzmaske genau genommen aus einer Basisschicht des ursprünglichen Maskenmaterials und einer darüberliegenden Schicht aus $SiO_x$ besteht.

Die mit dem bekannten Verfahren erzeugten Gräben weisen ein störendes, doppelt V-förmiges Tiefenprofil auf, da durch das fortlaufende Abscheiden von $SiO_x$ auf der Ätzmaske die Maskenstruktur selbst fortlaufend verändert wird. Darüber hinaus ergeben sich Probleme mit einer unerwünschten Ablagerung von $SiO_2$ auf den Seitenflächen grösserer Strukturen.

Aus der eingangs genannten Druckschrift ist weiterhin bekannt, bei der anisotropen Ätzung von Trennungsgräben für LSI-Schaltungen mittels RIE als Maske eine MgO-Schicht zu verwenden, über deren Abscheidung auf dem Siliziumsubstrat jedoch keine Angaben gemacht werden.

Schliesslich ist es aus der FR-A 2 081 915 bekannt, für Isolationszwecke auf einem Halbleitersubstrat Metalloxydschichten aus einer Lösung abzuscheiden.

Aufgabe der vorliegenden Erfindung ist es nun, ein Trockenätzverfahren anzugeben, das ohne zusätzliche, im Plasma-Reaktor ablaufende Prozesse die Herstellung von sehr feinen, tiefen und gleichmässigen Strukturen in einem Substrat ermöglicht.

Die Aufgabe wird bei einem Trockenätzverfahren der eingangs genannten Art durch die Merkmale aus dem Kennzeichen des Anspruchs 1 gelöst.

Die nicht durch Kathodenzerstäubung sondern auf chemischem Wege aus einer Lösung auf dem Substrat abgeschiedene Oxyd-Ätzmaske, z.B. $Al_2O_3$, erweist sich im Zusammenhang mit der Ätzung in einem fluorhaltigen Plasma überraschenderweise als ausserordentlich ätzresistent, so dass bei einem Siliziumsubstrat Ätzselektivitäten von nahezu 100 bei anisotropen Ätzvorgängen und von mehreren 100 bei isotropen Ätzvorgängen erreicht werden.

Die chemische Abscheidung beispielsweise einer $Al_2O_3$-Schicht erfolgt dabei vorzugsweise durch Wärmebehandlung einer Schicht aus einer Aluminiumchelat-Verbindung, die als Lösung auf das mit hoher Drehzahl rotierende Substrat aufgeschleudert worden ist. Auf andere Weise lassen sich auch andere Metalloxyd-Schichten herstellen, wie z.B. TiO_2 oder MgO, die ebenfalls als Ätzmasken geeignet sind.

Nachfolgend soll nun die Erfindung im Zusammenhang mit der Zeichnung anhand von Ausführungsbeispielen mit Al_2O_3-Schichten näher erläutert werden. Es zeigen:

Fig. 1 die schematische Darstellung des Aufschleudervorgangs, wie er gemäss einem bevorzugten Ausführungsbeispiel des erfindungsgemässen Verfahrens zum Auftragen der Ätzmaske auf das Substrat verwendet wird,

Fig. 2a–e verschiedene Stadien der Substratstrukturierung gemäss einem anderen bevorzugten Ausführungsbeispiel des erfindungsgemässen Verfahrens, insbesondere:

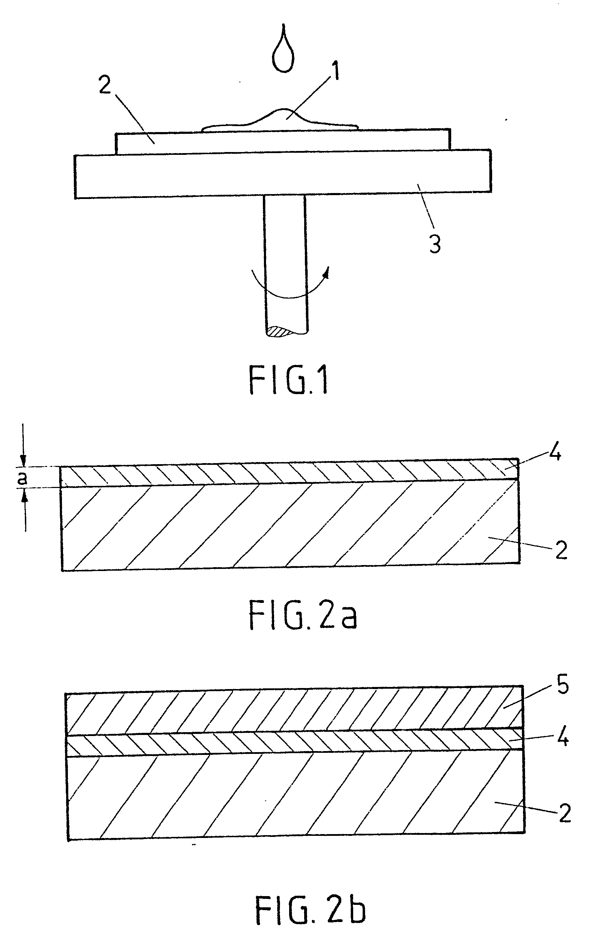

Fig. 2a das Substrat mit aufgebrachter Ätzmaske,

Fig. 2b die mit einer Photolackschicht versehene Anordnung aus Substrat und Ätzmaske,

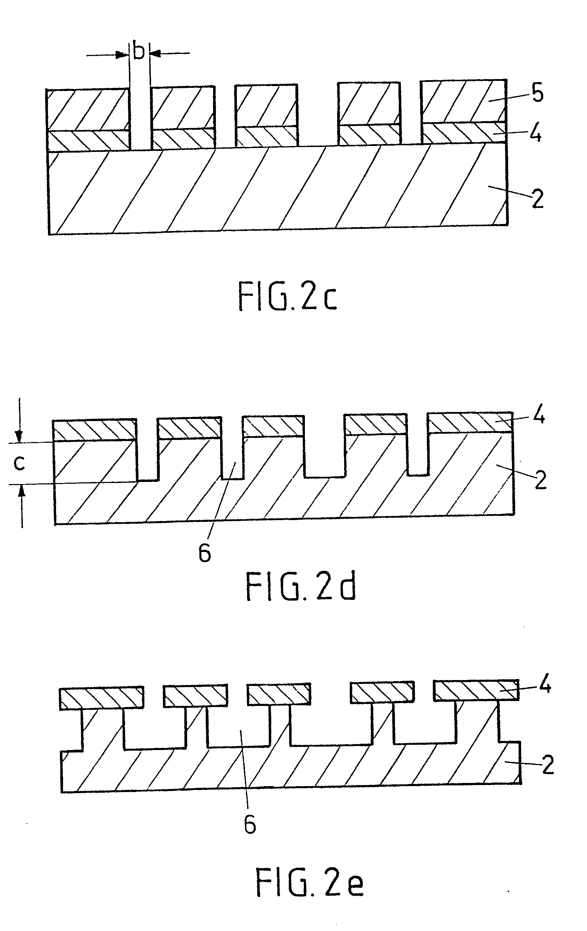

Fig. 2c die Anordnung aus Fig. 2b nach dem Belichtungs- und Entwicklungsvorgang,

Fig. 2d das anisotrop geätzte Substrat, und

Fig. 2e das isotrop geätzte Substrat.

Das erfindungsgemässe Trockenätzverfahren verwendet gemäss der Fig. 2a eine Ätzmaske 4 aus Oxyd, hier Al_2O_3, die auf einem Substrat 2, vorzugsweise aus Silizium, auf chemischem Wege abgeschieden wird. Besonders vorteilhaft zur Erzeugung sehr feiner Strukturen ist es, die Ätzmaske 4 mit einer Maskendicke a von 50–500 nm, vorzugsweise von 100–200 nm auszuführen.

Gemäss einem bevorzugten Ausführungsbeispiel mit einer Metalloxyd-Schicht aus Al_2O_3 erfolgt die chemische Abscheidung über einen Sol-Gel-Prozess mit Wärmebehandlung aus einer organischen Aluminiumchelat-Verbindung, die gemäss Fig. 1 als Aluminiumchelat-Lösung 1 in einem sogenannten «spin-on»-Verfahren auf das Substrat 2 aufgeschleudert wird, das auf einer Schleudervorrichtung 3 befestigt ist und mit Drehzahlen von mehreren 1000 Upm rotiert. Angaben über verschiedene, für dieses Verfahren geeignete organische Aluminium-Verbindungen können beispielsweise aus der US-PS 4 040 083 entnommen werden.

Beispiel:

Für die Herstellung einer Al_2O_3-Ätzmaske von etwa 110 nm Maskendicke geht man wie folgt vor: Eine geeignete Aluminiumchelat-Verbindung wird mit einem Lösungsmittel aus gleichen Teilen Äthanol und Toluol zu einer 20%-igen Lösung verarbeitet. Die Aluminiumchelatlösung wird bei 3000 Upm auf ein Si-Substrat in Scheibenform aufgeschleudert. Dann folgt die Hydrolyse während etwa 10 min bis 5 h, je nach Dicke der Schicht, bei Zimmertemperatur an normaler Luft, dann eine kurze, etwa 30 Minuten lange Temperung unter einer Infrarotlampe. Schliesslich wird das Substrat mit der aufgebrachten Schicht im Ofen an Sauerstoffatmosphäre etwa 1 h lang bei 60 °C vorgebacken und schliesslich etwa 1 h bei 350 °C getempert. Die Al_2O_3-Ätzmaske ist dann fertig und hat eine Dicke von ca. 115 nm.

Für die Strukturierung der Ätzmaske 4 wird auf die Ätzmaske 4 gemäss Fig. 2b eine Photolackschicht 5 aufgebracht, wobei vorzugsweise positiv arbeitender Photolack mit alkalischem Entwickler verwendet wird, wie er aus den Standard-Strukturierungsprozessen der Halbleitertechnologie bekannt ist. Auch das Aufbringen der Photolackschicht 5 erfolgt mit dem bereits beschriebenen «spin-on»-Verfahren, so dass die beiden Verfahrensschritte der Ätzmasken- und Photolackschichtherstellung in derselben Schleudervorrichtung 3 durchgeführt werden können.

Nach dem Trocknen der Photolackschicht 5 wird die Anordnung aus Fig. 2b unter Einsatz der üblichen Maskentechniken belichtet, wobei die Photolackschicht 5 auf vorbestimmten Flächen entsprechend der vorgegebenen Struktur der Photomaske belichtet wird. Bei dem nachfolgenden Entwicklungsprozess mit dem alkalischen Entwickler wird überraschenderweise nicht nur der belichtete Photolack gelöst, sondern auch die Al_2O_3-Schicht an jenen Stellen, wo sie dem Entwickler ausgesetzt ist, so dass nur durch den Entwicklungsvorgang bereits eine vollständig strukturierte Ätzmaske 4 gemäss Fig. 2c entsteht. Zusätzlich kann auch noch nach einem Hartbacken des Photolacks eine Ätzung in warmer (50–100 °C) Phosphorsäure erfolgen, wenn bei dickeren Al_2O_3-Schichten der Entwicklungsprozess für die Entfernung des Al_2O_3 an den freigelegten Stellen nicht ausreicht.

Die anschliessende Trockenätzung im fluorhaltigen Plasma eines Plasmareaktors erzeugt gemäss den Fig. 2d und 2e im Substrat 2 Ätzgräben 6 mit einer definierten Ätztiefe c. Bei einer anisotropen Prozessführung ist, wie in Fig. 2d dargestellt, die Breite der Ätzgräben 6 annähernd gleich der durch die Ätzmaske 4 vorgegebenen Ätzbreite b. Bei einer isotropen Prozessführung dagegen ergeben sich, wie in Fig. 2e gezeigt, durch die Unterätzung der Ätzmaske 4 wesentliche grössere Grabenbreiten.

Beispiel:

Das Si-Substrat wird im SF_6-Plasma anisotrop unter den folgenden Bedingungen geätzt:

| | |
|---|---|
| HF-Leistungsdichte: | 0,5 W/cm$^2$ |
| SF_6-Durchflussrate: | 2 sccm |
| Druck: | 50 µbar |

Die Ätzrate für das Si-Substrat beträgt bei dieser Prozessführung 367 nm/min, diejenige der Al_2O_3-Maske nur 3,86 nm/min, d.h. die Ätzselektivität erreicht bei dem anisotropen Ätzvorgang den erstaunlich hohen Wert von 95.

Als Struktur für eine Ätzung unter den im Beispiel angegebenen Bedingungen wurde im Experiment ein Strichgitterraster mit 50 µm breiten Stegen sowie 30 µm breiten Gräben verwendet; senkrecht dazu befand sich ein sehr schmaler Graben von etwa 2 µm Breite. Alle Gräben konnten unter den genannten Bedingungen gleichmässig etwa 11 µm tief ausgeätzt werden, ohne dass eine erkennbare Unterätzung der Al_2O_3-Ätzmaske auftrat.

Bei einer in einem anderen Experiment erprobten isotropen Prozessführung war der Abtrag der $Al_2O_3$-Schicht bei erreichter Ätztiefe von 9 µm nicht messbar, so dass für den isotropen Ätzvorgang sogar Ätzselektivitäten von mehreren 100 angenommen werden müssen.

Schliesslich sei darauf hingewiesen, dass die nach dem Entwickeln verbleibenden Reste der Photolackschicht 5 entweder vor dem Ätzvorgang durch geeignete Lösungsmittel abgewaschen oder beim Ätzen selber mit abgetragen werden können. Ebenso können nach der Ätzung die Reste der $Al_2O_3$-Ätzmaske leicht in warmer Phosphorsäure entfernt werden.

Selbstverständlich können, wenn z. B. grössere Ätztiefen gefordert werden, auch $Al_2O_3$-Ätzmasken mit grösserer Maskendicke a hergestellt werden, wozu entweder eine höherprozentige Aluminiumchelatlösung verwendet wird, oder der Prozessschritt des Aufschleuderns der Aluminiumchelatschicht mehrfach wiederholt wird.

Selbstverständlich ist das Maskenmaterial nicht auf das $Al_2O_3$ der Ausführungsbeispiele beschränkt. Über den erwähnten «Sol-Gel-Prozess» lassen sich eine Vielzahl von glasartigen Oxyd-Schichten aus Lösungen durch Aufschleudern oder Tauchen auf Halbleitersubstrate aufbringen. In Frage kommen hier neben $Al_2O_3$ die Oxyde der Elemente Ti, Zr, Hf, B, der seltenen Erden, sowie Mischungen dieser Oxyde.

Wichtig ist, dass sich die aufgebrachte Schicht strukturieren lässt und gegen fluorhaltiges Gas-Plasma chemisch stabil ist, was für die Oxyde der genannten Elemente in unterschiedlichem Ausmass der Fall ist.

Als Ausgangssubstanzen für die Herstellung der Lösung eignen sich insbesondere organische Verbindungen wie Acetylacetonate, Chelat-Verbindungen und Alkoholate.

Insgesamt stellt das erfindungsgemässe Trockenätzverfahren ein Verfahren zur Strukturierung von Substraten dar, bei dem auf sehr einfache Weise feine und sehr tiefe Strukturen mit gleichmässigem Tiefenprofil hergestellt werden können, und das sich insbesondere auch für die Serienfertigung von Halbleiterbauelementen eignet.

**Patentansprüche**

1. Trockenätzverfahren zur Strukturierung eines Substrats (2), bei welchem Verfahren auf das Substrat (2) eine anorganische Ätzmaske (4) in Form einer Oxid-Schicht aufgebracht und anschliessend strukturiert wird, wobei in vorbestimmten Flächen die Ätzmaske (4) abgetragen und die Oberfläche des Substrats (2) freigelegt wird, und bei welchem Verfahren das Material des Substrats (2) in den vorbestimmten Flächen durch einen Ionenätzprozess in einem fluorhaltigen Plasma abgetragen wird, dadurch gekennzeichnet, dass die Oxid-Schicht auf dem Substrat chemisch aus einer Lösung abgeschieden wird.

2. Trockenätzverfahren nach Anspruch 1, dadurch gekennzeichnet, dass die Oxid-Schicht wenigstens eines der Oxide $Al_2O_3$, $TiO_2$, MgO, $ZrO_2$ und $B_2O_3$ enthält.

3. Trockenätzverfahren nach Anspruch 1, dadurch gekennzeichnet, dass die Oxid-Schicht in einer Maskendicke (a) von 50–500 nm, vorzugsweise von 100–200 nm, verwendet wird.

4. Trockenätzverfahren nach Anspruch 1, dadurch gekennzeichnet, dass die Oxid-Schicht aus einer gelösten organischen Verbindung, durch Eintauchen des Substrats (2) in die Lösung oder durch Aufschleudern der Lösung auf das Substrat (2), auf dem Substrat (2) abgeschieden wird.

5. Trockenätzverfahren nach Anspruch 4, dadurch gekennzeichnet, dass die Oxid-Schicht eine $Al_2O_3$-Schicht ist, dass die $Al_2O_3$-Schicht durch thermische Zersetzung einer organischen Aluminium-Verbindung, vorzugsweise einer Aluminiumchelat-Verbindung hergestellt wird, und dass die organische Aluminium-Verbindung zunächst in einem organischen Lösungsmittel, vorzugsweise einer Mischung aus gleichen Teilen Äthanol und Toluol, gelöst, auf das mit einer Drehzahl von mehreren 1000 Upm, vorzugsweise von etwa 3000 Upm, rotierende Substrat (2) aufgeschleudert und die entsprechende Schicht bei einer Temperatur oberhalb 300 °C für mehr als 10 min getempert wird.

6. Trockenätzverfahren nach Anspruch 5, dadurch gekennzeichnet, dass die auf das Substrat (2) aufgeschleuderte, die organische Aluminium-Verbindung enthaltende Schicht vor dem Tempern zunächst mehrere Minuten bei Zimmertemperatur an Luft belassen, anschliessend etwa 30 Minuten mit einer Infrarotlampe bestrahlt und schliesslich für etwa 1 h bei 60 °C unter Inertgas-Atmosphäre vorgebacken wird.

7. Trockenätzverfahren nach Anspruch 1, dadurch gekennzeichnet, dass für den Ionenätzprozess $SF_6$-Gas mit einer Durchflussrate von etwa 2 sccm bei einem Druck von etwa 50 µbar und einer HF-Leistungsdichte von ungefähr $0,5 \text{ W/cm}^2$ verwendet wird.

8. Trockenätzverfahren nach Anspruch 1, dadurch gekennzeichnet, dass zur Strukturierung auf die Ätzmaske (4) eine Photolackschicht (5) aufgetragen, in den vorbestimmten Flächen belichtet und dort durch einen nachfolgenden Entwicklungsprozess wieder entfernt wird, und der Photolack nach Beendigung des Entwicklungsprozesses hartgebacken und das Substrat (2) mit seiner Ätzmaske (4) in warme Phosphorsäure eingetaucht wird, und dass die Photolackschicht (5) durch Aufschleudern auf die rotierende Ätzmaske (4) aufgetragen wird.

9. Trockenätzverfahren nach Anspruch 5, dadurch gekennzeichnet, dass für das Aufschleudern die organische Aluminium-Verbindung in einer etwa 20%-igen Lösung verwendet wird.

10. Trockenätzverfahren nach Anspruch 4, dadurch gekennzeichnet, dass Ätzmasken (4) grösserer Dicke durch mehrfaches, aufeinanderfolgendes Aufbringen von einzelnen Schichten der organischen Verbindung hergestellt werden.

**Claims**

1. Dry etching process for patterning a substrate (2), in which process an inorganic etching mask (4), in the form of an oxide layer, is applied to the substrate (2) and then patterned, with the etching mask (4) and the surface of the substrate (2) being exposed in predetermined areas, and in which process the material of the substrate (2) is removed in the predetermined areas by an ion etching process in a fluorine-containing plasma, characterised in that
– the oxide layer is deposited chemically from a solution on the substrate.

2. Dry etching process according to Claim 1, characterised in that the oxide layer contains at least one of the oxides $Al_2O_3$, $TiO_2$, MgO, $ZrO_2$ and $B_2O_3$.

3. Dry etching process according to Claim 1, characterised in that the oxide layer is used in a mask thickness (a) of 50–500 nm, preferably of 100–200 nm.

4. Dry etching process according to Claim 1, characterised in that the oxide layer is deposited on the substrate (2) from a dissolved organic compound by dipping the substrate (2) in the solution or by spinning the solution onto the substrate (2).

5. Dry etching process according to Claim 4, characterised in that the oxide layer is an $Al_2O_3$ layer, that the $Al_2O_3$ layer is prepared by thermal decomposition of an organic aluminium compound, preferably an aluminium chelate compound, and that the organic aluminium compound is first dissolved in an organic solvent, preferably a mixture of equal parts of ethanol and toluene, spun onto the substrate (2) which is rotating at a speed of several 1000 rpm, preferably of around 3000 rpm, and the relevant layer is annealed at a temperature above 300 °C for more than 10 min.

6. Dry etching process according to Claim 5, characterised in that the layer containing the organic aluminium compound and spun onto the substrate (2) is first left in air at room temperature for several minutes before annealing, then irradiated with an infrared lamp for about 30 minutes and finally pre-baked in an inert gas atmosphere for about 1 hour at 60 °C.

7. Dry etching process according to Claim 1, characterised in that $SF_6$ gas with a flow rate of about 2 sccm is used at a pressure of about 50 μbar and an HF power density of approximately 0.5 W/cm² for the ion etching process.

8. Dry etching process according to Claim 1, characterised in that a photoresist layer (5) is deposited on the etching mask (4) for the patterning process, exposed in the predetermined areas and then again removed from these areas by a subsequent development process, and the photoresist is baked hard after termination of the development process and the substrate (2) with its etching mask (4) is dipped in warm phosphoric acid, and that the photoresist layer (5) is deposited on the rotating etching mask (4) by spinning on.

9. Dry etching process according to Claim 5, characterised in that the organic aluminium compound is used in an approximately 20% solution for spinning on.

10. Dry etching process according to Claim 4, characterised in that etching masks (4) of greater thickness are prepared by depositing individual layers of the organic compound several times in sequence.

## Revendications

1. Procédé de gravure à sec pour produire un modèle sur un substrat (2), procédé au cours duquel un masque de gravure minéral (4), sous forme d'une couche d'oxyde, est appliqué au substrat (2) et ensuite pourvu d'un modèle, le masque de gravure (4) et la surface du substrat (2) étant exposés dans des zones prédéterminées, et procédé au cours duquel le matériau du substrat (2) est retiré dans les zones prédéterminées par un procédé de gravure aux ions dans un plasma contenant du fluor, caractérisé en ce que la couche d'oxyde est déposée chimiquement à partir d'une solution sur le substrat.

2. Procédé de gravure à sec selon la revendication 1 caractérisé en ce que la couche d'oxyde contient au moins l'un des oxydes $Al_2O_3$, $TiO_2$, MgO, $ZrO_2$ et $B_2O_3$.

3. Procédé de gravure à sec selon la revendication 1 caractérisé en ce que l'on utilise la couche d'oxyde à une épaisseur de masque (a) de 50–500 nm, de préférence de 100–200 nm.

4. Procédé de gravure à sec selon la revendication 1 caractérisé en ce que la couche d'oxyde est déposée sur le substrat (2) à partir d'un composé organique dissous en trempant le substrat (2) dans la solution ou en déposant par filage par rotation la solution sur le substrat (2).

5. Procédé de gravure à sec selon la revendication 4 caractérisé en ce que la couche d'oxyde est une couche d'$Al_2O_3$, en ce que la couche d'$Al_2O_3$ est préparée par décomposition thermique d'un composé d'aluminium organique, de préférence d'un composé chélate d'aluminium et en ce que le composé d'aluminium organique est d'abord dissous dans un solvant organique, de préférence un mélange de parties égales d'éthanol et de toluène déposé par filage par rotation sur le substrat (2) qui tourne à une vitesse de plusieurs milliers de rpm, de préférence d'environ 3000 rpm, et la couche correspondante est durcie à une température supérieure à 300 °C pendant plus de 10 mn.

6. Un procédé de gravure à sec selon la revendication 5, caractérisé en ce que la couche contenant le composé d'aluminium organique et déposée par filage par rotation sur le substrat (2) est d'abord abandonnée à l'air à la température ambiante pendant plusieurs minutes avant d'être durcie, puis irradiée à l'aide d'une lampe à infrarouges pendant environ 30 minutes, et finalement précuite dans une atmosphère de gaz inerte pendant environ 1 heure à 60 °C.

7. Procédé de gravure à sec selon la revendication 1 caractérisé en ce que l'on utilise du gaz $SF_6$ avec un débit d'environ 2 sccm, à une pression d'environ 50 μbars et à une densité de puissance en HF d'environ 0,5 W/cm² pour le procédé de gravure aux ions.

8. Procédé de gravure à sec selon la revendication 1 caractérisé en ce que l'on dépose une couche de réserve anti-acide (5) sur le masque de gravure (4) pour le procédé de production du modèle, en ce qu'on l'expose dans les zones prédéterminées et qu'on la retire ensuite de ces zones par un procédé de développement ultérieur et en ce que la réserve anti-acide est cuite dure après la fin du procédé de développement et en ce que le substrat (2) avec son masque de gravure (4) est trempé dans l'acide phosphorique chaud et en ce que la couche de réserve anti-acide (5) est déposée sur le masque de gravure tournant par filage par rotation.

9. Procédé de gravure à sec selon la revendication 5 caractérisé en ce que l'on utilise le composé d'aluminium organique dans une solution à environ 20% pour le filage par rotation.

10. Procédé de gravure à sec selon la revendication 4 caractérisé en ce que l'on prépare des masques de gravure (4) d'épaisseur plus importante en déposant des couches individuelles du composé organique plusieurs fois consécutives.

FIG.1

FIG.2a

FIG. 2b

FIG.2c

FIG.2d

FIG.2e